# EUROPÄISCHE PATENTSCHRIFT

(11) **EP 2 047 529 B1**
(45) Veröffentlichungstag und Bekanntmachung des Hinweises auf die Patenterteilung: **21.07.2010**
(21) Anmeldenummer: 07801614.4
(22) Anmeldetag: 11.08.2007
(51) Int. Cl.: H01L 41/04, H01L 41/09

(54) **Elektronische Steuerungseinheit für einen als Trimorph ausgebildeten piezokeramischen Biegewandler**
Electronic control device for a piezoceramic bending transducer in form of a trimorph
Module de commande électronique pour un transducteur de flexion piézocéramique sous forme d'un trimorphe

(43) Veröffentlichungstag der Anmeldung: 15.04.2009
(73) Patentinhaber: FESTO AG & Co. KG, 73734 Esslingen (DE)
(72) Erfinder: WIRTL, Hannes, 86956 Schongau (DE)
(74) Vertreter: Vetter, Hans
(86) Internationale Anmeldenummer: PCT/EP2007/007119
(87) Internationale Veröffentlichungsnummer: WO 2009/021530

(56) Entgegenhaltungen:
- EP-A- 1 717 500
- WO-A-89/07345
- DE-A1- 19 701 334
- JP-A- 59 108 378
- US-A- 4 916 349

## Beschreibung

Die Erfindung betrifft eine elektronische Steuerungseinrichtung für einen als Trimorph ausgebildeten piezokeramischen Biegewandler, der aus zwei Piezokeramikplatten mit dazwischen angeordneter passiver Zwischenlage besteht.

In bekannter Weise wird bei einem solchen Trimorph zur mechanischen Biegung in die eine Richtung eine Spannungsquelle an der ersten Piezokeramikplatte angelegt und zur mechanischen Biegung in die andere Richtung eine Spannungsquelle an die andere Piezokeramikplatte. Es ist selbstverständlich auch möglich, durch entsprechende Umschaltmittel die Spannung der Spannungsquelle entweder an die eine oder an die andere Piezokeramikplatte anzulegen. In allen Fällen ist die jeweils andere Piezokeramikplatte passiv.

Eine Aufgabe der vorliegenden Erfindung besteht darin, jeweils für den mechanischen Biegevorgang beide Piezokeramikplatten zu aktivieren, ohne dass sich die Zahl der Spannungsquellen erhöht.

Eine Anordnung, bei der über einen Spannungsteiler beide Piezokeramikschichten aktiviert werden, seht aus JP-A-59-108378 hervor.

Diese Aufgabe wird erfindungsgemäß durch eine Steuerungseinrichtung mit den Merkmalen des Anspruchs 1 gelöst.

Durch die beiden Spannungsteiler wird in vorteilhafter Weise mit nur einer Spannungsquelle eine bipolare Ansteuerung des Trimmorphs erreicht, bei der beide Keramiken aktiv sind. Hierdurch werden in der einen Piezokeramikplatte Zugspannungen und in der anderen Piezokeramikplatte gleichzeitig Druckspannungen durch gegenpoligen Betrieb dieser Piezokeramikplatte erzeugt, sodass die auf Zugspannung belastete Keramik geringer belastet wird, zum einen, weil eine geringere Spannung angelegt werden muss, und zum anderen, weil die andere Piezokeramikplatte den Biegevorgang unterstützt. Dennoch ist nur eine Spannungsquelle für den Biegevorgang in die eine Richtung erforderlich.

Da somit jede der Piezokeramikplatten geringer belastet ist, erhöht sich die Lebensdauer und treten geringere Verschleißerscheinungen auf.

Durch die in den Unteransprüchen aufgeführten Maßnahmen sind vorteilhafte Weiterbildungen und Verbesserungen der im Anspruch 1 angegebenen elektronischen Steuerungseinrichtung möglich.

Die beiden ersten Widerstandszweige der beiden Spannungsteiler weisen zweckmäßigerweise jeweils die Reihenschaltung einer Diode mit einem Widerstandselement auf. Anstelle des Widerstandselements kann in vorteilhafter Weise auch eine Z-Diode vorgesehen sein, die einen zusätzlichen Schutz gegen Überspannungen bildet. Die Diode und die Z-Diode sind dabei jeweils gegensinnig gepolt. Zur Erzielung der gewünschten gegensinnigen Spannungen sind die Kathoden der beiden Dioden der beiden ersten Widerstandszweige direkt oder indirekt, also beispielsweise über einen Widerstand, miteinander verbunden.

Zur Spannungs- beziehungsweise Strombegrenzung kann jeweils noch zwischen die ersten Widerstandszweige und die Piezokeramikplatten ein weiteres Widerstandselement geschaltet werden.

Um eine Biegebewegung in beide Richtungen durchführen zu können, ist der zweite Spannungsteiler mit einer zweiten Spannungsquelle verbindbar, wobei die Spannungsquellen alternativ zur Erzeugung der beiden gegensinnigen Biegebewegungen einschaltbar sind. Alternativ hierzu kann auch die erste Spannungsquelle umschaltbar an den ersten oder den zweiten Spannungsteiler anlegbar ausgebildet sein, beispielsweise mittels eines Umschalters, sodass auch bei Biegebewegungen in beide Richtungen nur eine einzige Spannungsquelle erforderlich ist.

Der Trimorph eignet sich in besonderer Weise als Ventilschaltglied eines Ventils. Die erforderlichen elektronischen Bauteile können dabei zweckmäßigerweise auf einem Flexleiter des Ventils angeordnet sein, wobei ein solcher Flexleiter häufig ohnehin vorhanden ist.

Zwei Ausführungsbeispiele der Erfindung sind in der Zeichnung dargestellt und in der nachfolgenden Beschreibung näher erläutert. Es zeigen:
- Figur 1: den Schaltplan eines ersten Ausführungsbeispiels,
- Figur 2: ein Spannungsdiagramm zur Erläuterung der Wirkungs- weise,
- Figur 3: den Schaltplan eines zweiten Ausführungsbeispiels der Erfindung und
- Figur 4: ein Spannungsdiagramm zur Erläuterung der Wirkungs- weise des in Figur 3 dargestellten Ausführungsbei- spiels.

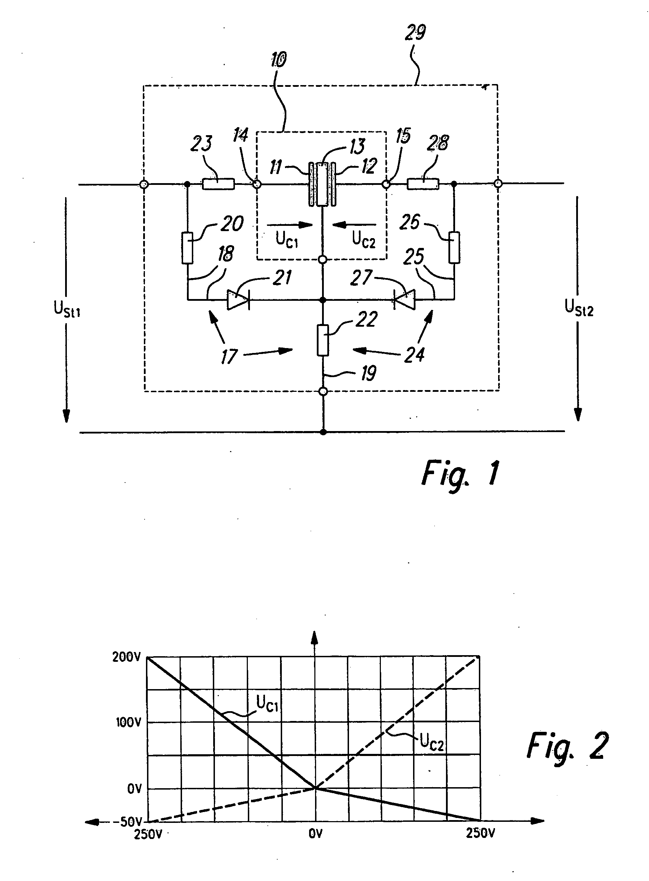

Der in Figur 1 schematisch dargestellte, als Trimorph 10 ausgebildete piezokeramische Biegewandler besteht in bekannter Weise aus zwei Piezokeramikplatten 11, 12, zwischen denen eine passive Zwischenlage 13 angeordnet ist. Das Trägermaterial der Zwischenlage 13 ist dabei gewöhnlich mit den Piezokeramikplatten 11, 12 verklebt oder auf andere Weise daran fixiert. Entsprechend der Zahl der Piezokeramikplatten 11, 12 und der passiven Zwischenlage 13 besitzt der Trimorph 10 drei elektrische Anschlüsse 14-16.

Ein erster Spannungsteiler 17 besitzt zwei Widerstandszweige 18, 19, wobei der erste Widerstandszweig 18 aus der Reihenschaltung eines Widerstandselements 20 mit einer Diode 21 besteht und der zweite Widerstandszweig 19 aus einem Widerstandselement 22. Andere bekannte Ausgestaltungen von Spannungsteilern 17 sind prinzipiell ebenfalls möglich.

Der Abgriff des Spannungsteilers 17 zwischen den Widerstandzweigen 18, 19 ist über den elektrischen Anschluss 16 mit der passiven Zwischenlage 13 verbunden. Das andere Anschlussende des ersten Widerstandszweigs 18 ist über ein weiteres Widerstandselement 23 und über den elektrischen Anschluss 14 mit der ersten Piezokeramikplatte 11 verbunden.

Ein zweiter Spannungsteiler 24 besteht wiederum aus zwei Widerstandszweigen 25, 19, wobei der erste Widerstandszweig 25 symmetrisch zum ersten Widerstandszweig 18 des ersten Spannungsteilers 17 ausgebildet ist und ebenfalls aus der Reihenschaltung eines Widerstandselements 26 mit einer Diode 27 besteht. Beide Spannungsteiler 17, 24 besitzen denselben zweiten Widerstandszweig 19. Der erste Widerstandszweig 25 des zweiten Spannungsteilers 24 ist entsprechend über ein Widerstandselement 28 und über den elektrischen Anschluss 15 mit der zweiten Piezokeramikplatte 12 verbunden.

Die gesamte Anordnung kann beispielsweise in einem fluidischen Ventil 29 angeordnet sein, wobei der Trimorph 10 das Ventilglied bildet. Die elektronischen Bauteile können beispielsweise auf einem häufig schon vorhandenen Flexleiter des Ventils 29 integriert sein, wie dies aus der EP 1717500 A1 bekannt ist. Soll der Trimorph 10 nur einen Biegevorgang in die eine Biegerichtung ausführen, so muss lediglich eine Spannungsquelle U_{St1} an den ersten Spannungsteiler 17 angelegt werden. Die Spannungsverhältnisse dabei sind in der linken Diagrammhälfte des in Figur 2 abgebildeten Diagramms dargestellt. Die Spannung U_{C1} ist dabei die Spannung zwischen der ersten Piezokeramikplatte 11 und der Zwischenlage 13, während die gestrichelt dargestellte gegensinnig gepolte Spannung U_{C2} die Spannung zwischen der zweiten Piezokeramikplatte 12 und der Zwischenlage 13 ist. Beide Spannungen U_{C1} und U_{C2} werden mit Hilfe der Spannungsquelle U_{St1} und der beiden Spannungsteiler 17, 24 erzeugt, indem die Spannung in der Mittellage durch die Spannungsteiler 17, 24 angehoben wird. In der Piezokeramikplatte 11 entsteht dabei eine Zugspannung, während in der Piezokeramikplatte 12 eine Druckspannung erzeugt wird, sodass beide Piezokeramikplatten 11, 12 eine Bewegung in dieselbe Biegerichtung bewirken.

Wird eine zweite Spannungsquelle U_{St2} an den zweiten Spannungsteiler 24 angelegt, während die erste Spannungsquelle U_{St1} ausgeschaltet wird, so kehren sich die Verhältnisse um, und der Trimorph 10 führt eine Biegebewegung in die entgegengesetzte Richtung aus. Die Spannungsverhältnisse dabei sind in der rechten Diagrammhälfte von Figur 2 dargestellt.

Die beiden Dioden 21, 27 sind gegensinnig gepolt, das heißt, ihre Kathoden sind miteinander verbunden. Diese Verbindung kann selbstverständlich auch indirekt über wenigstens ein Widerstandselement erfolgen. Diese Dioden verhindern einen Kurzschluss der Spannung U_{St1}, wenn U_{St2} zu 0 wird, und umgekehrt.

Ist eine Biegebewegung des Trimorphs 10 in die beiden entgegengesetzten Biegerichtungen erforderlich, so kann anstelle der beiden Spannungsquellen U_{St1} und U_{St2} auch nur eine Spannungsquelle vorgesehen sein, die dann über einen nicht dargestellten elektrischen Umschalter wahlweise an die beiden Spannungsteiler 17 und 24 angelegt wird.

Die Biegebewegung des Trimorphs 10 bei einer Ausbildung als Ventilglied ist beispielsweise bei einem als 3/2-Wegeventil ausgebildeten fluidischen Ventil 29 erforderlich, während bei einem 2/2-Wegeventil lediglich eine Biegebewegung in eine Biegerichtung notwendig ist.

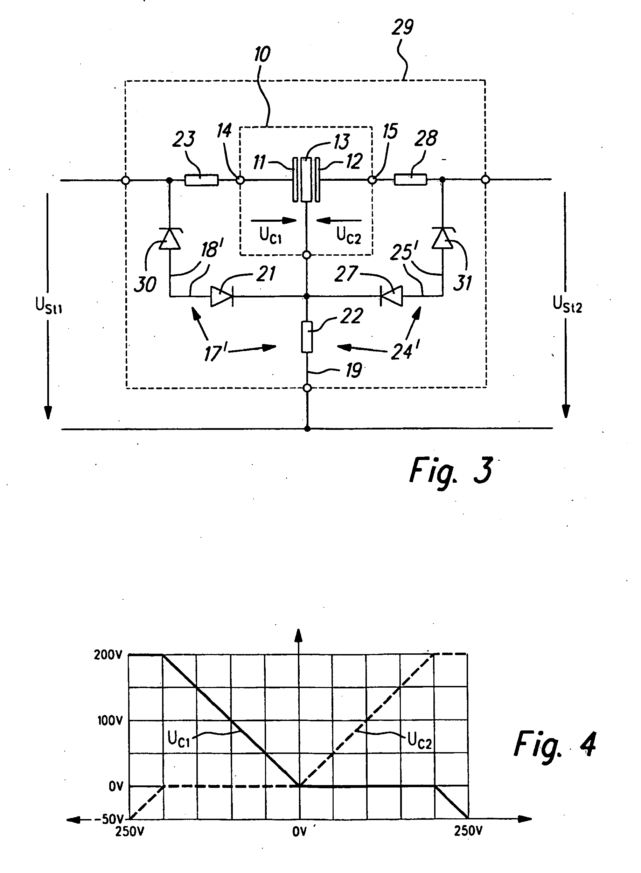

Bei dem in Figur 3 dargestellten zweiten Ausführungsbeispiel sind gleiche oder gleichwirkende Bauteile mit denselben Bezugszeichen versehen und nicht nochmals beschrieben. Bei einem modifizierten ersten Spannungsteiler 17' tritt lediglich anstelle des ersten Widerstandszweigs 18 ein modifizierter erster Widerstandszweig 18', der anstelle des Widerstandselements 20 ein Z-Diode 30 aufweist. Entsprechend besitzt ein modifizierter erster Widerstandszweig 25' des zweiten modifizierten Spannungsteilers 24' ein Z-Diode 31.

Durch die beiden Z-Dioden 30, 31 treten die in Figur 4 dargestellten, gegenüber Figur 2 abweichenden Spannungsverläufe auf. Die Z-Dioden 30, 31 bilden einen zusätzlichen Schutz gegen Überspannungen. Die Spannungen U_{C1} und U_{C2} werden in beide Biegerichtungen auf 200 V begrenzt, wobei dieser Wert selbstverständlich nur beispielhaft ist. Die jeweils eine Druckspannung ausübende Piezokeramikplatte wird dabei bis zu einer Spannung von 200 V der Spannungsquelle U_{St1} beziehungsweise U_{St2} konstant gehalten und fällt dann auf einen Wert von -50 V ab. Dies bedeutet, dass die eine Druckspannung ausübende Piezokeramikplatte jeweils nur bei Spannungen über 200 V zur Unterstützung der Bewegung aktiviert wird. Durch die Wahl der Bauteile der Spannungsteiler 17, 24 können die Spannungsverhältnisse in gewünschter Weise eingestellt werden.

## Patentansprüche

1. Elektronische Steuerungseinrichtung für einen als Trimorph (10) ausgebildeten piezokeramischen Biegewandler, der aus zwei Piezokeramikplatten (11, 12) mit dazwischen angeordneter passiver Zwischenlage (13) besteht, mit einem ersten, aus zwei Widerstandszweigen (18, 18', 19) bestehenden, von einer ersten Spannungsquelle (U_{St1}) beaufschlagbaren Spannungsteiler (17; 17'), dessen erster Widerstandszweig (18; 18') die erste Piezokeramikplatte (11) mit der Zwischenlage (13) verbindet, mit einem zweiten, aus zwei Widerstandszweigen (25, 25', 19) bestehenden Spannungsteiler (24; 24'), dessen erster Widerstandszweig (25; 25') die zweite Piezokeramikplatte (12) mit der Zwischenlage (13) verbindet, wobei der zweite Widerstandszweig (19) des ersten Spannungsteilers (17; 17') den zweiten Widerstandszweig (19) auch des zweiten Spannungsteilers (24; 24') bildet.

2. Steuerungseinrichtung nach Anspruch 1, **dadurch gekennzeichnet, dass** die beiden ersten Widerstandszweige (18, 25) jeweils die Reihenschaltung einer Diode (21, 27) mit einem Widerstandselement (20, 26) aufweisen.

3. Steuerungseinrichtung nach Anspruch 1, **dadurch gekennzeichnet, dass** die beiden ersten Widerstandszweige (18', 25') jeweils die Reihenschaltung einer Diode (21, 27) mit einer Z-Diode (30, 31) aufweisen.

4. Steuerungseinrichtung nach Anspruch 3, **dadurch gekennzeichnet, dass** die Dioden (21, 27) und die Z-Dioden (30, 31) jeweils gegensinnig gepolt sind.

5. Steuerungseinrichtung nach einem der Ansprüche 2 bis 4, **dadurch gekennzeichnet, dass** die Kathoden der beiden Dioden (21, 27) der beiden ersten Widerstandszweige (18, 25; 18', 25') direkt oder indirekt miteinander verbunden sind.

6. Steuerungseinrichtung nach einem der vorhergehenden Ansprüche, **dadurch gekennzeichnet, dass** jeweils zwischen die ersten Widerstandszweige (18, 25; 18', 25') und die Piezokeramikplatten (11, 12) ein Widerstandselement (23, 28) geschaltet ist.

7. Steuerungseinrichtung nach einem der vorhergehenden Ansprüche, **dadurch gekennzeichnet, dass** der zweite Spannungsteiler (24; 24') mit einer zweiten Spannungsquelle (U_{St2}) verbindbar ist, wobei die Spannungsquellen (U_{St1} beziehungsweise U_{St2}) alternativ einschaltbar sind.

8. Steuerungseinrichtung nach einem der Ansprüche 1 bis 6, **dadurch gekennzeichnet, dass** die erste Spannungsquelle (U_{St1}) umschaltbar an den ersten (17; 17') oder den zweiten Spannungsteiler (24; 24') anlegbar ist.

9. Steuerungseinrichtung nach einem der vorhergehenden Ansprüche, **dadurch gekennzeichnet, dass** der Trimorph (10) als Ventilschaltglied eines Ventils (29) ausgebildet ist.

10. Steuerungseinrichtung nach Anspruch 9, **dadurch gekennzeichnet, dass** die elektronischen Bauteile auf einem Flexleiter des Ventils (29) angeordnet oder integriert sind.

## Claims

1. Electronic control unit for a piezoceramic bending transducer in the form of a trimorph (10) and comprised of two piezoceramic plates (11, 12) with a passive intermediate layer (13) between them, with a first voltage divider (17; 17') comprised of two resistance branches (18, 18', 19) and able to be supplied from a first voltage source (U_{St1}) and with a first resistance branch (18, 18') connecting the first piezoceramic plate (11) with the intermediate layer (13), with a second voltage divider (24; 24') comprised of two resistance branches (25, 25', 19), of which the first resistance branch (25; 25') connects the second piezoceramic plate (12) with the intermediate layer (13), wherein the second resistance branch (19) of the first voltage divider (17; 17') also forms the second resistance branch (19) of the second voltage divider (24; 24').

2. Control unit according to claim 1, **characterised in that** the two first resistance branches (18, 25) each have a diode (21, 27) connected in series with a resistance element (20, 26).

3. Control unit according to claim 1, **characterised in that** two first resistance branches (18', 25') each have a diode (21, 27) connected in series with a Z diode (30, 31).

4. Control unit according to claim 3, **characterised in that** the diodes (21, 27) and the Z diodes (30, 31) are in each case of opposite polarity.

5. Control unit according to any of claims 2 to 4, **characterised in that** the cathodes of the two diodes (21, 27) of the two first resistance branches (18, 25; 18', 25') are connected directly or indirectly to one another.

6. Control unit according to any of the preceding claims, **characterised in that** in each case a resistance element (23, 28) is inserted between the first resistance branch (18, 25; 18', 25') and the piezoceramic plates (11, 12).

7. Control unit according to any of the preceding claims, **characterised in that** the second voltage divider (24; 24') may be connected to a second voltage source (U_{St2}), wherein the voltage sources (U_{St1} or U_{St2}) may be connected alternately.

8. Control unit according to any of claims 1 to 6, **characterised in that** the first voltage source (U_{St1}) may be applied alternatively to the first (17; 17') or the second voltage divider (24; 24').

9. Control unit according to any of the preceding claims, **characterised in that** the trimorph (10) is designed as the valve switching element of a valve (29).

10. Control unit according to claim 9, **characterised in that that** the electronic components are mounted on or integral with the flexible conductor of the valve (29).

## Revendications

1. Dispositif de commande électronique pour un transducteur de flexion piézocéramique réalisé sous la forme d'un trimorphe (10), lequel se compose de deux plaques piézocéramiques (11, 12) présentant un palier intermédiaire (13) passif disposé entre ces dernières, avec un premier diviseur de tension (17 ; 17') se composant de deux branches à résistance (18, 18', 19), pouvant être alimenté par une première source de tension (Uₛₜ₁), dont la première branche à résistance (18 ; 18') connecte la première plaque piézocéramique (11) au palier intermédiaire (13), avec un deuxième diviseur de tension (24 ; 24') se composant de deux branches à résistance (25, 25', 19), dont la première branche à résistance (25 ; 25') connecte la deuxième plaque piézocéramique (12) au palier intermédiaire (13), la deuxième branche à résistance (19) du premier diviseur de tension (17 ; 17') formant également la deuxième branche à résistance (19) du deuxième diviseur de tension (24 ; 24').

2. Dispositif de commande selon la revendication 1, **caractérisé en ce que** les deux premières branches à résistance (18, 25) présentent respectivement le montage en série d'une diode (21, 27) avec un élément à résistance (20, 26).

3. Dispositif de commande selon la revendication 1, **caractérisé en ce que** les deux premières branches à résistance (18', 25') présentent respectivement le montage en série d'une diode (21, 27) avec une diode Z (30, 31).

4. Dispositif de commande selon la revendication 3, **caractérisé en ce que** les diodes (21, 27) et les diodes Z (30, 31) sont respectivement polarisées en sens inverse.

5. Dispositif de commande selon l'une quelconque des revendications 2 à 4, **caractérisé en ce que** les cathodes des deux diodes (21, 27) des deux premières branches à résistance (18, 25 ; 18', 25') sont connectées entre elles directement ou indirectement.

6. Dispositif de commande selon l'une quelconque des revendications précédentes, **caractérisé en ce qu'**un élément à résistance (23, 28) est placé respectivement entre les premières branches à résistance (18, 25 ; 18', 25') et les plaques piézocéramiques (11, 12).

7. Dispositif de commande selon l'une quelconque des revendications précédentes, **caractérisé en ce que** le deuxième diviseur de tension (24 ; 24') peut être connecté à une deuxième source de tension (Uₛₜ₂), les sources de tension (Uₛₜ₁ et/ou Uₛₜ₂) pouvant être mises en circuit de manière alternative.

8. Dispositif de commande selon l'une quelconque des revendications 1 à 6, **caractérisé en ce que** la première source de tension (Uₛₜ₁) peut être placée de manière à pouvoir commuter au niveau du premier (17 ; 17') ou au niveau du deuxième (24 ; 24') diviseur de tension.

9. Dispositif de commande selon l'une quelconque des revendications précédentes, **caractérisé en ce que** le trimorphe (10) est réalisé comme un élément de commutation à valve d'une valve (29).

10. Dispositif de commande selon la revendication 9, **caractérisé en ce que** les composants électroniques sont disposés ou intégrés dans un conducteur flex de la valve (29).
